# EUROPÄISCHE PATENTSCHRIFT

(11) **EP 3 794 916 B1**
(45) Veröffentlichungstag und Bekanntmachung des Hinweises auf die Patenterteilung: **21.06.2023**
(21) Anmeldenummer: 19725075.6
(22) Anmeldetag: 14.05.2019
(51) Int. Cl.: H05K 7/20

(54) **GEHÄUSE FÜR EINEN INVERTER MIT KÜHLSYSTEM FÜR EINEN ELEKTROANTRIEB**
HOUSING FOR AN INVERTER HAVING A COOLING SYSTEM FOR AN ELECTRIC DRIVE
BOÎTIER POUR UN ONDULEUR AVEC SYSTÈME DE REFROIDISSEMENT POUR UN ENTRAÎNEMENT ÉLECTRIQUE

(30) Priorität: 15.05.2018 DE 102018111619
(43) Veröffentlichungstag der Anmeldung: 24.03.2021
(73) Patentinhaber: Valeo eAutomotive Germany GmbH, 91056 Erlangen (DE)
(72) Erfinder: SCHMITT, Matthias, 91126 Schwabach (DE); KOURGIALIS, Alexandros, 95195 Röslau (DE); KAISER, Anna, 90402 Nürnberg (DE); ALEXANDRU, Andrei, 90768 Fürth (DE); HOYLER, Christoph, 91241 Kirchensittenbach (DE); NOBEL, Michael, 90425 Nürnberg (DE)
(74) Vertreter: Valeo Powertrain Systems
(86) Internationale Anmeldenummer: PCT/EP2019/062334
(87) Internationale Veröffentlichungsnummer: WO 2019/219675

(56) Entgegenhaltungen:
- JP-A- 2008 295 139
- JP-A- 2014 103 733
- US-A1- 2009 021 971
- US-A1- 2015 152 987

## Beschreibung

Die Erfindung betrifft ein Gehäuse für einen Inverter mit Kühlsystem für einen Elektroantrieb.

### Stand der Technik

Elektroantriebe sind allgemein bekannt und finden zunehmend Anwendung für den Antrieb von Fahrzeugen.

Die US 2009/021971 A1 offenbart eine Inverteranordnung für ein Fahrzeug. Die Inverteranordnung umfasst Leistungsmodule und ein Gehäuse mit einem Einlass für ein Kühlfluid, einem Auslass für ein Kühlfluid und einem dazwischenliegenden Kanal für das Kühlfluid. Der Kanal erstreckt sich von Einlass aus entlang einer ersten Seitenwand des Gehäuses, und von einer gegenüberliegenden zweiten Seitenwand des Gehäuses zum Auslass. Zwischen den Seitenwänden ist der Kanal entlang einer Endwand des Gehäuses verbunden.

Für den Antrieb eines Wechselstrommotors aus Batterien ist ein Inverter erforderlich, ein solcher Inverter ist beispielsweise in EP 3 188 352 gezeigt.

EP 3 188 352 A1 offenbart ein Gehäuse mit einem Kühlkanal für den Inverter. Die Kühlflüssigkeit tritt durch eine Öffnung in das Gehäuse ein und umspült die Schaltungselemente und verlässt danach das Gehäuse durch eine weitere Öffnung.

EP 3 300 239 A1 zeigt ein Gehäuse für einen Inverter mit zwei Öffnungen für die Kühlflüssigkeit. Die Flüssigkeit tritt in das Gehäuse ein, umspült die Schaltungselemente und verlässt danach das Gehäuse.

Weitere Gehäuse sind aus der US 2015/152987 A1, der JP 2014 103733 A und der JP 2008 295139 A bekannt.

### Aufgabe und Lösung

Aufgabe der vorliegenden Erfindung ist es, ein Kühlsystem für einen Inverter eines Elektroantriebs dahingehend zu verbessern, dass die Bauform möglichst kompakt ist, aber gleichzeitig eine ausreichende Kühlung erfolgt.

Gelöst wird die Aufgabe durch ein Gehäuse mit einem Kühlsystem gemäß dem unabhängigen Anspruch. Weitere vorteilhafte Ausgestaltungen der Erfindung sind Gegenstand der Unteransprüche.

Erfindungsgemäß weist ein Gehäuse für einen Inverter Schaltungselemente und ein Kühlsystem auf, wobei das Gehäuse vier Öffnungen aufweist und das Kühlsystem zwei im Gehäuse angeordnete Kanäle umfasst, die jeweils mit zwei unterschiedlichen Öffnungen verbunden sind und ein Kondensator unterhalb des Gehäuses angeordnet ist, wobei zwei Öffnungen von unterschiedlichen Kanälen mittels eines außerhalb des Gehäuses angeordneten Verbindungselements kommunizierend verbunden sind und das Verbindungselement starr ausgebildet ist und seitlich an dem Kondensator vorbei verläuft.

Die Schaltungselemente können durch die beiden Kühlkanäle effektiv gekühlt werden. Eine Verbindung der Kühlkanäle im Gehäuse kann unterbleiben und so eine besonders kompakte Bauform des Gehäuses erzielt werden.

Das Verbindungselement kann eine Kühlflüssigkeit von einem Kanal in einen anderen Kanal leiten. Die beiden Kanäle und das Verbindungselement können einen durchgängigen Kühlkanal im Gehäuse bilden. Durch die Anordnung des Kühlelements außerhalb des Gehäuses ist auch eine Kühlung der Kühlflüssigkeit möglich. Das Verbindungselement kann Kühlrippen aufweisen oder aus einem wärmeleitenden Material sein. Die Form des Verbindungselements kann an die bauliche Form des Invertergehäuses angepasst sein.

Die starre Ausführung hat den Vorteil, dass innerhalb des Verbindungselementes es zu keinem wesentlichen Druckabfall kommen kann.

Trotz eines voluminösen Kondensators kann somit das Gehäuse kompakt bleiben. Die Kühlung des Kondensators ist im Vergleich zu den Schaltungselementen weniger kritisch, da die Halbleiter in den Schaltungselementen hitzeempfindlicher als der Kondensator sind.

Der Kondensator kann außerhalb des Gehäuses für die Schaltungselemente angeordnet sein und trotzdem zwischen den Schaltungselementen über eine Busbar angebunden sein. Dies ermöglicht eine kurze Anbindung des Kondensators an die Schaltungselemente.

Das Verbindungselement kann aus Stahl, Edelstahl, festem Kunststoff oder Aluminium gefertigt sein. Ebenfalls ist ein glattes Innenrohr für das Verbindungselement bevorzugt.

In einer bevorzugten Ausgestaltung der Erfindung können die beiden Kanäle im Gehäuse parallel verlaufen und das Verbindungselement (13) wenigstens zwei Winkel, insbesondere im Bereich von 75 bis 115 Grad, aufweisen.

Mit diesen Winkeln kann das Verbindungselement um den Kondensator geführt werden und ermöglicht einen kompakten Aufbau des Gehäuses.

Erfindungsgemäß sind eine Öffnung als Kühlmitteleinlass und eine weitere Öffnung als Kühlmittelauslass ausgestaltet.

Ebenfalls ist es möglich, dass das Verbindungselement zwei weitere Winkel im gleichen Bereich aufweist, also insgesamt vier Winkel umfasst. Alle oder einzelnen Winkel können auch im Wesentlichen rechtwinklig ausgebildet sein. Im Wesentlichen bedeutet dabei, das die Winkel bis auf Fertigungstoleranzen rechtwinklig sind.

Bevorzugt kann das Verbindungselement in oder an die zwei Öffnungen geklebt sein.

Durch das Einkleben werden keine O-Ringe benötigt und eine zusätzliche Befestigung des Verbindungselementes am Gehäuse ist nicht nötig. Ferner kann eine Höhe der Öffnung zum Anschluss des Verbindungselementes im Vergleich zu den anderen Öffnungen niedriger ausfallen, weil kein Platz für einen O-Ring vorgesehen werden muss.

Ein Anschluss der Kanäle des Inverters an einen Kühlmittelkreislauf kann durch die Öffnungen erfolgen. Durch jeweils zwei Öffnungen strömt eine Kühlflüssigkeit in die beiden Kanäle und durch die beiden anderen Öffnungen kann die Kühlflüssigkeit das Gehäuse wieder verlassen. Es ist eine unabhängige Durchleitung von Kühlflüssigkeit durch jeden der beiden Kanäle möglich.

In einer weiteren Ausgestaltung der Erfindung kann der Kühlmitteleinlass, der Kühlmittelauslass, die beiden Kanäle, die beiden weiteren Öffnungen, das Verbindungselement und einem zwischen Kühlmittelauslass und Kühlmitteleinlass angeordneten Wärmetauscher einen Kühlkreislauf bilden.

Die Verbindung dieser Elemente ermöglicht eine Kühlung des Gehäuses mit nur einem Kühlkreislauf. Durch das Verbindungselement kann das Gehäuse kompakt aufgebaut werden, sodass zwischen den Kanälen im Inneren des Gehäuses kein Platz benötigt wird.

Bevorzugt können die Schaltungselemente oberhalb der Kanäle angeordnet sein. Durch die unter den Schaltungselementen liegenden Kanäle ist eine effektive Kühlung möglich. Das Gehäuse kann ungefähr so lang wie die Schaltungselemente sein, da eine im Gehäuse liegende Verbindung zwischen den Kanälen unnötig ist. Die vorhandene Kanallänge kann daher komplett zur Kühlung der Schaltungselemente genutzt werden.

Weiter bevorzugt kann zwischen den beiden Kanälen eine Busbar angeordnet sein. Zwischen den Kanälen ist durch die fehlende Verbindung der Kanäle Platz für eine Busbar.

Die Schaltungselemente können an diese Busbar im Gehäuse angeschlossen werden. Die Gefahr eines Kurzschlusses durch Kühlflüssigkeit ist vermindert, da die Busbar ausreichend Abstand von den Kühlkanälen aufweist.

Die Kühlung der Schaltungselemente erfolgt durch die Kühlflüssigkeit in den Kanälen. Die Kanäle sind über ein Verbindungselement außerhalb des Gehäuses verbunden. Das Verbindungselement ist so ausgestaltet, dass es ausreichend vom Kondensator beabstandet ist.

In einer weiteren Ausgestaltung der Erfindung können der Kondensator und die Schaltungselemente mit der Busbar verbunden sein.

Der Kondensator kann daher als Zwischenkreiskondensator des Inverters verwendet werden ohne im Gehäuse des Inverters angeordnet zu sein. Ein besonders kompakter Aufbau des Inverters ist damit möglich.

Erfindungsgemäß weist ein Fahrzeug ein Gehäuse gemäß einer bevorzugten Ausgestaltung auf.

Weiter bevorzugt können mindestens zwei Öffnungen mit einem Fahrzeugkühlsystem verbunden sein. Das vorhandene Fahrzeugkühlsystem kann als Reservoir für die Kühlflüssigkeit dienen und diese Flüssigkeit nach dem Durchleiten durch das Gehäuse auch herunter kühlen.

### Figurenbeschreibung

Figur 1 zeigt eine Außenansicht einer Unterseite eines Gehäuses für einen Inverter.
Figur 2 zeigt eine Innenansicht der in Figur 1 gezeigten Unterseite des Gehäuses.
Figur 3 zeigt eine Außenansicht einer Unterseite eines Gehäuses für einen Inverter mit einem Verbindungselement.
Figur 4 zeigt eine Seitenansicht eines Gehäuses mit einem Verbindungselement.
Figur 5 zeigt eine weitere Seitenansicht eines Gehäuses mit einem Verbindungselement.
Figur 6 zeigt eine Ausführungsform eines Verbindungselementes als Drauf- und Seitenansicht.
Figur 7 zeigt eine Außenansicht einer Unterseite einer weiteren Ausführungsform eines Gehäuses für einen Inverter mit einem Verbindungselement.
Figur 8 zeigt eine Seitenansicht einer weiteren Ausführungsform eines Gehäuses mit einem Verbindungselement.
Figur 9 zeigt eine weitere Seitenansicht einer weiteren Ausführungsform eines Gehäuses mit einem Verbindungselement.
Figur 10 zeigt eine weitere Ausführungsform eines Verbindungselementes als Drauf- und Seitenansicht.

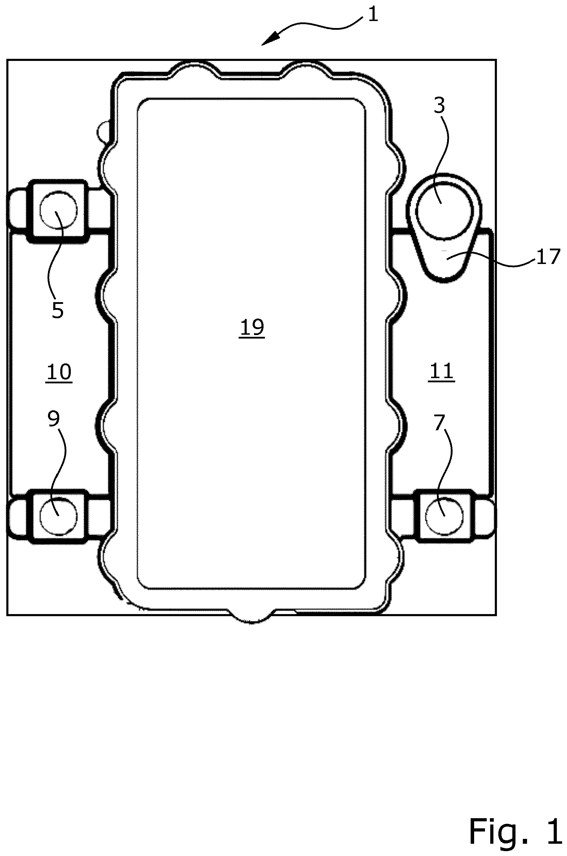

In Figur 1 ist die Unterseite eines Gehäuses 1 dargestellt. Die untere Gehäuseschale weist vier Öffnungen 3, 5, 7, 9 auf. Jeweils zwei Öffnungen 3 und 7, sowie 5 und 9 sind auf der anderen Seite der Gehäuseschale durch einen Kanal 10, 11 verbunden, der durch eine Ausbuchtung im Gehäuse 1 gebildet ist. Auf das Gehäuse 1 ist ein weiteres Kondensatorgehäuse aufgesetzt, in dem ein Kondensator 19 angeordnet ist. Eine der Öffnungen 3 besitzt einen Flansch mit einer Fläche, in die eine Ausnehmung 17 für eine Schraube eingebracht werden kann. Mittels dieser Schraubverbindung kann ein druckbelasteter Kühlmittelschlauch am Gehäuse befestigt werden.

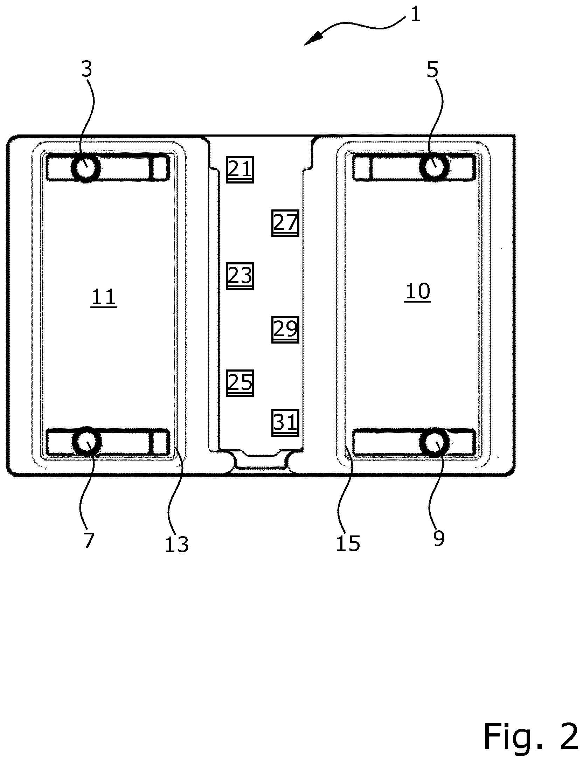

In Figur 2 ist die Innenansicht der Gehäuseschale dargestellt. Die Anordnung der Öffnungen 3, 5, 7, 9 ist im Gegensatz zur Figur 1 seitenverkehrt. Die Kanäle 10, 11 verbinden die Öffnungen und sind nach außen gewölbt. Eine Kühlflüssigkeit kann durch die Kanäle und Öffnungen fließen. Die Öffnungen befinden sich innerhalb der Ausnehmungen für die Kanäle, wobei die Ausnehmungen durch ein Dichtmittel 13, 15 umlaufen werden. Auf die Ausnehmungen kann eine Trennwand aufgesetzt werden, die in Verbindung mit dem Dichtmittel das Gehäuseinnere vor der Flüssigkeit im Kühlkanal schützt.

Zwischen den Kanälen ist eine Busbar 21, 23, 25, 27, 31 angeordnet, die mit den verschiedenen Halbbrücken der Schaltungselemente verbunden ist. Die Busbar kann durch die Gehäusewand nach außen geführt werden.

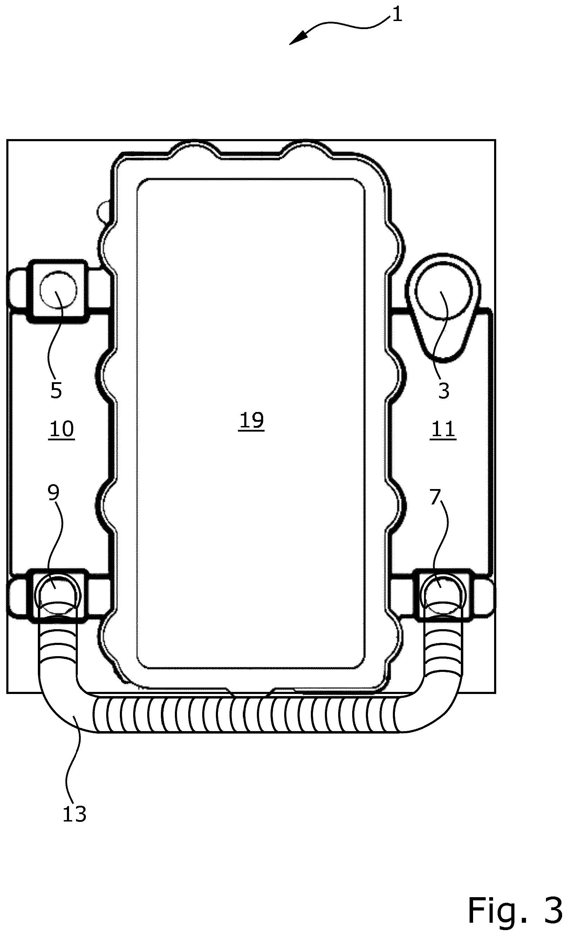

In Figur 3 ist wiederum die Außenansicht des Gehäuses 1 gezeigt. Zwei Öffnungen 7, 9 sind mittels eines Verbindungselements 13 verbunden. Das Rohr 13 ermöglicht ein Fließen des Kühlmittels von einem Kanal 10, 11 in den anderen Kanal außerhalb des Gehäuses 1.

Das Verbindungselement 13 ist derart gekrümmt, dass es einen ausreichenden Abstand zum Kondensatorgehäuse mit dem Kondensator 19 aufweist.

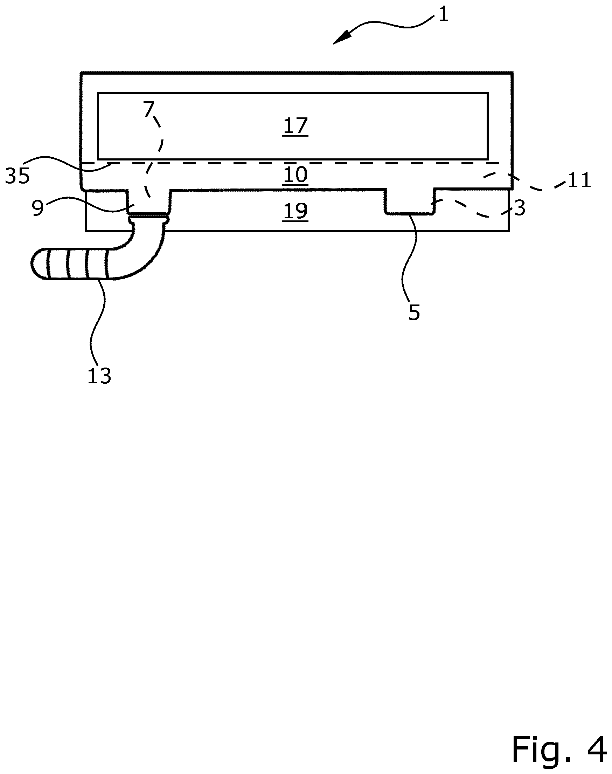

In Figur 4 ist eine Seitenansicht des Gehäuses 1 mit einem Rohr als Verbindungselement 13 dargestellt. Die Öffnungen 3, 7 sind hinter den Öffnungen 5, 9 angeordnet und werden von diesen verdeckt. Innerhalb des Gehäuses 1 sind die Kanäle geformt, die von einer wärmeleitenden Platte 35 dicht abgeschlossen werden. Über der Platte 35 sind die Schaltungselemente 17 angeordnet, die Wärme über die Platte 35 an die Kühlflüssigkeit in den Kanälen 10 abgeben können. Durch das Verbindungselement 13 kann Kühlflüssigkeit von einem Kanal in den anderen Kanal strömen und das Gehäuse 1 benötigt lediglich einen Kühlanschluss des Fahrzeugs über die Öffnungen 3, 5 als Kühlmitteleinlass und -auslass.

Unterhalb des Gehäuses 1 ist ein Kondensator 19 angeordnet, der über eine nach außen geführte Busbar mit den im Gehäuse liegenden Schaltungselementen verbunden ist.

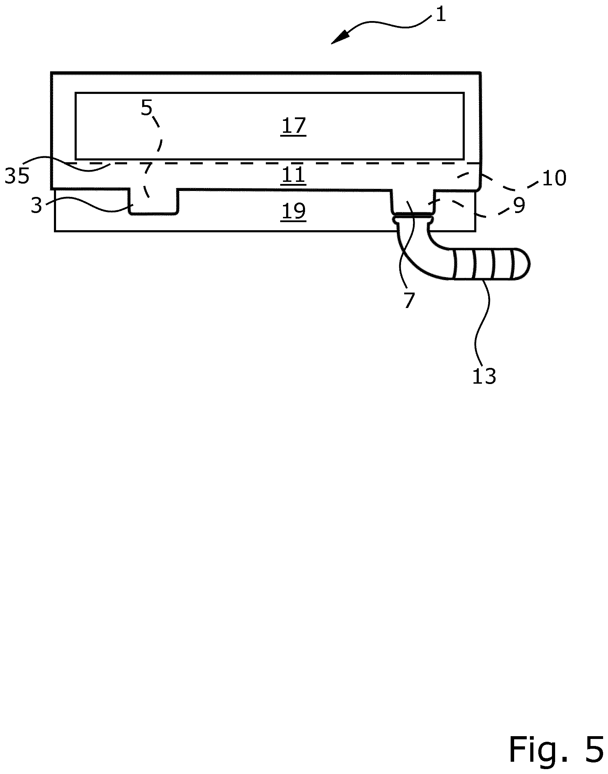

Figur 5 zeigt das Gehäuse von der gegenüberliegenden Seite der in Figur 4 dargestellten Gehäuseseite.

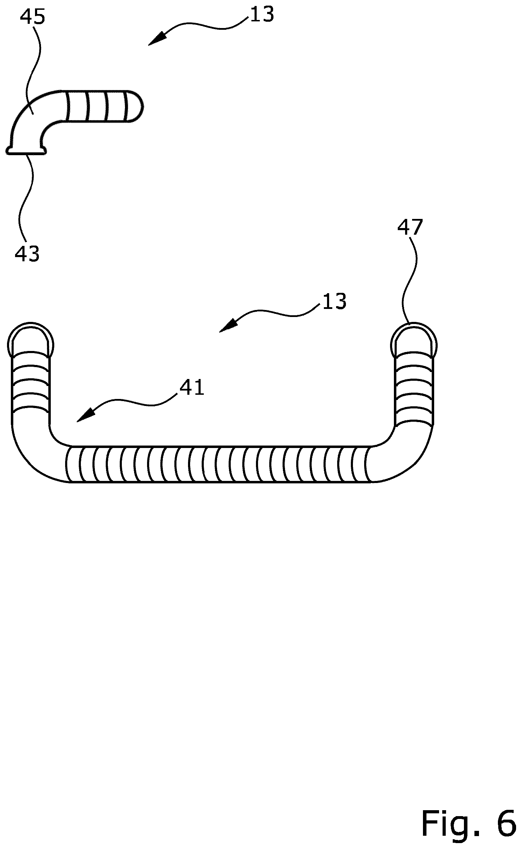

Figur 6 zeigt eine Ausführungsform eines Verbindungselements 13. Das als Rohr ausgestaltete Verbindungselement 13 führt vom Gehäuse weg 45 und knickt 41 nach etwas Abstand vom Gehäuse um ungefähr 90 Grad in Richtung der anderen Öffnung. Durch diese Form wird einerseits ausreichend Abstand zum Gehäuse für die Kühlung des Rohres erreicht aber andererseits der beengte Bauraum innerhalb eines Fahrzeugs berücksichtigt.

Am Einlass 43 des Rohres befindet sich eine Dichtung. Mittels einer Überwurfmuffe kann das Rohr an die Öffnungen geschraubt werden und dadurch die Dichtung zwischen Öffnung und Rohr komprimiert werden.

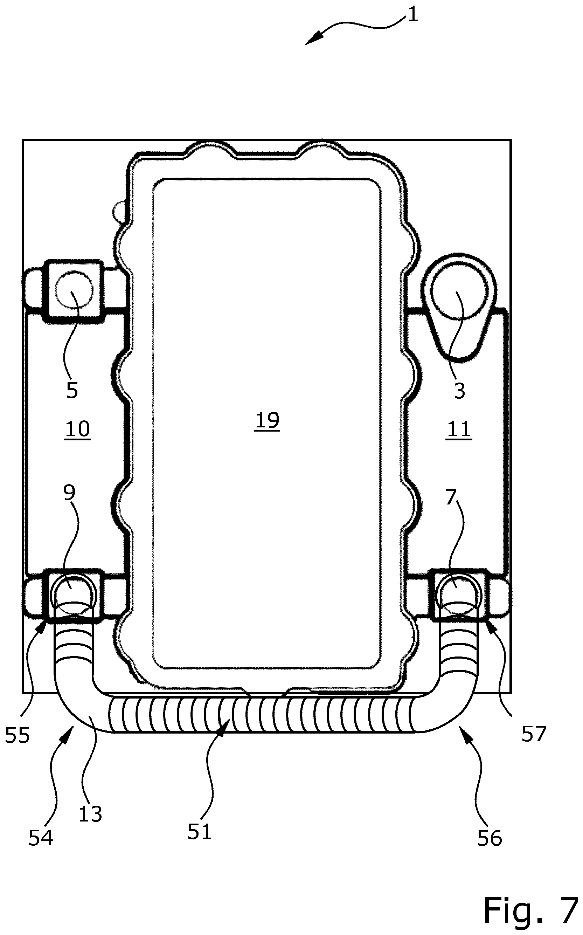

Figur 7 zeigt das Gehäuse 1 mit einem Rohr 13 als Verbindungselement. Das Rohr verläuft von der Öffnung 9 im Wesentlichen rechtwinklig und parallel zum Kondensator 19. Am Ende des Kondensators 19 weist das Rohr eine weitere im Wesentlichen rechtwinkligen Abknickung in Richtung der anderen Öffnung 7 auf und verläuft parallel zum Kondensator 19 in Richtung der anderen Öffnung 7. Nach dem das Rohr 13 am Kondensator vorbeigelaufen ist, weist das Rohr 13 wiederum zwei rechtwinklige Abknickungen 56, 57 auf, die spiegelbildlich zu den beiden vorhergehenden Abknickungen 54, 55 sind. Ferner weist das Rohr 13 Kühlrippen 51 auf.

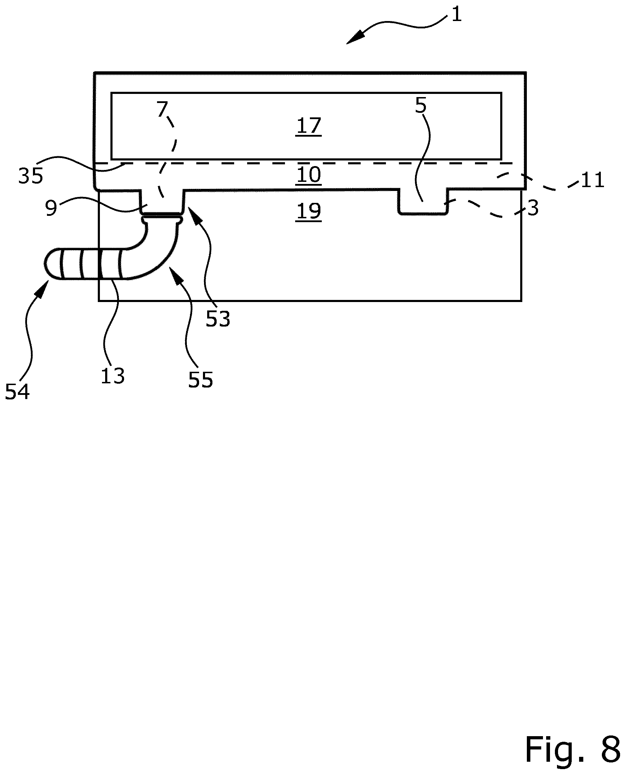

In Figur 8 ist eine Seitenansicht des Gehäuses 1 ähnlich zu Figur 7 gezeigt. Das Rohr 13 weist zwei sichtbare Winkel 54, 55 auf. Die weiteren Winkel des Rohres 13 sind durch die Seitenansicht verdeckt. Das Rohr 13 ist mittels Kleber 53 an oder in die Öffnung 9 geklebt.

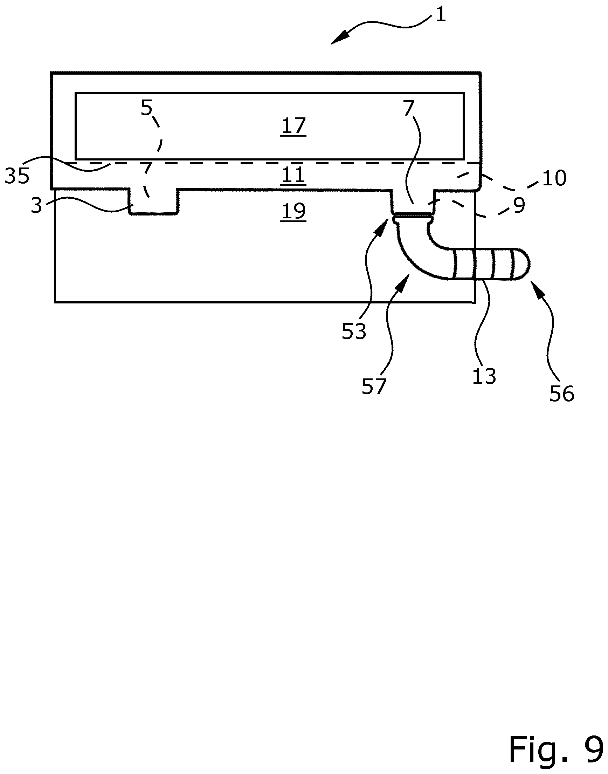

In Figur 9 ist eine weitere Seitenansicht des Gehäuses 1 ähnlich zu Figur 7 gezeigt. Das Rohr 13 weist zwei sichtbare Winkel 56, 57 auf. Die weiteren Winkel des Rohres 13, die in Figur 8 zu sehen sind, sind durch die Seitenansicht verdeckt. Das Rohr 13 ist mittels Kleber 53 an oder in die Öffnung 9 geklebt.

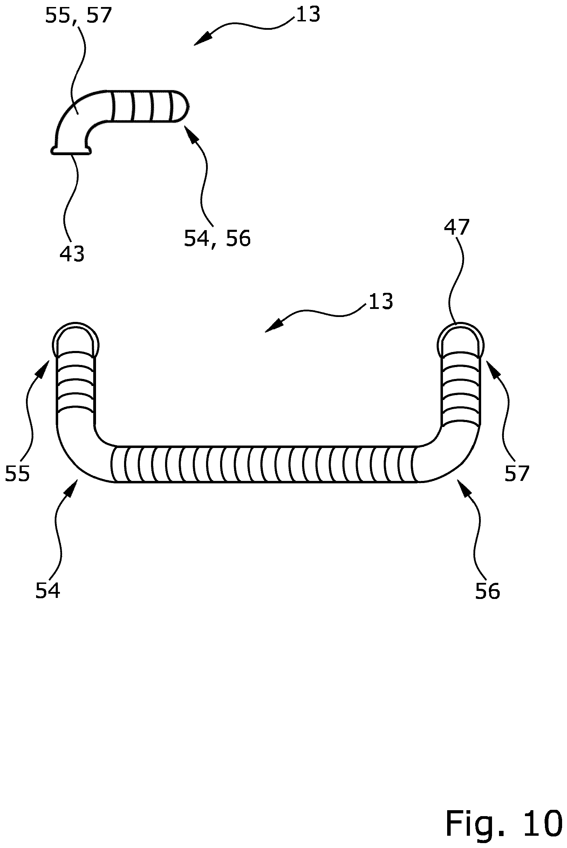

Figur 10 zeigt eine weitere Ausführungsform eines Verbindungselements 13. Das als Rohr ausgestaltete Verbindungselement 13 führt vom Gehäuse in einem Winkel von ungefähr 90 Grad 55 in Richtung der anderen Öffnung. Durch diese Form wird einerseits ausreichend Abstand zum Gehäuse für die Kühlung des Rohres erreicht aber andererseits der beengte Bauraum innerhalb eines Fahrzeugs berücksichtigt.

Ferner weist das Rohr 13 einen weiteren ungefähr rechten Winkel 54 auf, der das Rohr um den nicht dargestellten Kondensator führt. Im Anschluss darin weist das Rohr zwei weitere zu den ersten beiden spiegelbildliche Winkel 56, 57 auf.

Am Einlass 43 des Rohres 13 befindet sich Klebstoff, womit das Rohr 13 an oder in die Öffnungen geklebt wird und dadurch eine dichte Verbindung zwischen Öffnung und Rohr hergestellt wird.

## Patentansprüche

1. Gehäuse (1) für einen Inverter umfassend Schaltungselemente (17) und ein Kühlsystem, wobei das Gehäuse vier Öffnungen (3, 5, 7, 9) aufweist und das Kühlsystem zwei im Gehäuse angeordnete Kanäle (10, 11) umfasst, die jeweils mit zwei unterschiedlichen der Öffnungen (3, 5, 7, 9) verbunden sind, und ein Kondensator (19) unterhalb des Gehäuses (1) angeordnet ist, wobei eine der Öffnungen (3) als Kühlmitteleinlass ausgestaltet ist, eine weitere der Öffnungen (5) als Kühlmittelauslass ausgestaltet ist und zwei weitere der Öffnungen (7, 9) von unterschiedlichen Kanälen (10, 11) mittels eines außerhalb des Gehäuses angeordneten Verbindungselements (13) kommunizierend verbunden sind und das Verbindungselement (13) starr ausgebildet ist und seitlich an dem Kondensator (19) vorbei verläuft.

2. Gehäuse (1) gemäß Anspruch 1, wobei die beiden Kanäle (10, 11) im Gehäuse (1) parallel verlaufen und das Verbindungselement (13) wenigstens zwei Winkel, insbesondere im Bereich von 75 bis 115 Grad, aufweist.

3. Gehäuse (1) gemäß Anspruch 1 oder 2, wobei das Verbindungselement (13) in oder an die zwei weiteren Öffnungen (7, 9) geklebt ist.

4. Gehäuse (1) gemäß einem der vorherigen Ansprüche , wobei der Kühlmitteleinlass, der Kühlmittelauslass, die beiden Kanäle, die beiden weiteren Öffnungen (7, 9), das Verbindungselement (13) und einem zwischen Kühlmittelauslass und Kühlmitteleinlass angeordneten Wärmetauscher einen Kühlkreislauf bilden.

5. Gehäuse (1) gemäß einem der vorherigen Ansprüche, wobei die Schaltungselemente (17) oberhalb der Kanäle (10, 11) angeordnet sind.

6. Gehäuse (1) gemäß einem der vorherigen Ansprüche, wobei zwischen den beiden Kanälen (10, 11) eine Busbar (21, 23, 25, 27, 29, 31) angeordnet ist.

7. Gehäuse (1) gemäß Anspruch 6, wobei der Kondensator (19) und die Schaltungselemente (17) mit der Busbar (21, 23, 25, 27, 29, 31) verbunden sind.

8. Inverter, umfassend ein Gehäuse (1) gemäß einem der vorherigen Ansprüche.

9. Fahrzeug mit einem Gehäuse (1) gemäß einem der Ansprüche 1 bis 7.

10. Fahrzeug mit einem Gehäuse (1) gemäß Anspruch 9, wobei mindestens zwei der Öffnungen (3, 5, 7, 9) mit einem Fahrzeugkühlsystem des Fahrzeugs verbunden sind.

## Claims

1. Housing (1) for an inverter comprising circuit elements (17) and a cooling system, wherein the housing has four openings (3, 5, 7, 9) and the cooling system comprises two channels (10, 11) which are arranged in the housing and each of which is connected to two different openings (3, 5 ,7, 9), and a capacitor (19) is arranged below the housing (1), wherein one of the openings (3) is configured as a coolant inlet, a further of the openings (5) is configured as a coolant outlet and two further openings (7, 9) of different channels (10, 11) are connected in a communicating manner by means of a connecting element (13) which is arranged outside the housing and the connecting element (13) is of rigid design and runs past the side of the capacitor (19).

2. Housing (1) according to Claim 1, wherein the two channels (10, 11) run in parallel in the housing (1) and the connecting element (13) has at least two bends, in particular in the range of from 75 to 115 degrees.

3. Housing (1) according to Claim 1 or 2, wherein the connecting element (13) is adhesively bonded into or onto the two further openings (7, 9).

4. Housing (1) according to one of the preceding claims, wherein the coolant inlet, the coolant outlet, the two channels, the two further openings (7, 9), the connecting element (13) and a heat exchanger which is arranged between the coolant outlet and the coolant inlet form a cooling circuit.

5. Housing (1) according to one of the preceding claims, wherein the circuit elements (17) are arranged above the channels (10, 11).

6. Housing (1) according to one of the preceding claims, wherein a busbar (21, 23, 25, 27, 29, 31) is arranged between the two channels (10, 11).

7. Housing (1) according to Claim 6, wherein the capacitor (19) and the circuit elements (17) are connected to the busbar (21, 23, 25, 27, 29, 31).

8. Inverter comprising a housing (1) according to one of the preceding claims.

9. Vehicle having a housing (1) according to one of Claims 1 to 7.

10. Vehicle having a housing (1) according to Claim 9, wherein at least two of the openings (3, 5, 7, 9) are connected to a vehicle cooling system of the vehicle.

## Revendications

1. Boîtier (1) destiné à un onduleur comprenant des éléments de circuit (17) et un système de refroidissement, le boîtier comportant quatre ouvertures (3, 5, 7, 9} et le système de refroidissement comprenant deux conduits (10, 11) disposés dans le boîtier qui sont reliés chacun à deux ouvertures différentes parmi les ouvertures (3, 5, 7, 9), et un condensateur (19) étant disposé au-dessous du boîtier (1), l'une des ouvertures (3) étant conçue comme une entrée d'agent de refroidissement, une autre des ouvertures (5) étant conçue comme une sortie d'agent de refroidissement et deux autres des ouvertures (7, 9) de différents conduits (10, 11) étant reliées de manière communicative au moyen d'un élément de liaison (13) disposé à l'extérieur du boîtier et l'élément de liaison (13) étant conçu pour être rigide et s'étendant latéralement le long du condensateur (19) .

2. Boîtier (1) selon la revendication 1, les deux conduits (10, 11) s'étendant parallèlement dans le boîtier (1) et l'élément de liaison (13) présentant au moins deux angles, en particulier dans la plage de 75 à 115 degrés.

3. Boîtier (1) selon la revendication 1 ou 2, l'élément de liaison (13) étant collé dans ou sur les deux autres ouvertures (7, 9).

4. Boîtier (1) selon l'une des revendications précédentes, l'entrée d'agent de refroidissement, la sortie d'agent de refroidissement, les deux conduits, les deux autres ouvertures (7, 9), l'élément de liaison (13) et un échangeur de chaleur, disposé entre la sortie d'agent de refroidissement et l'entrée d'agent de refroidissement, formant un circuit de refroidissement.

5. Boîtier (1) selon l'une des revendications précédentes, les éléments de circuit (17) étant disposés au-dessus des conduits (10, 11).

6. Boîtier (1) selon l'une des revendications précédentes, une barre omnibus (21, 23, 25, 27, 29, 31) étant disposée entre les deux conduits (10, 11).

7. Boîtier (1) selon la revendication 6, le condensateur (19) et les éléments de circuit (17) étant reliés à la barre omnibus (21, 23, 25, 27, 29, 31).

8. Onduleur, comprenant un boîtier (1) selon l'une des revendications précédentes.

9. Véhicule comprenant un boîtier (1) selon l'une des revendications 1 à 7.

10. Véhicule comprenant un boîtier (1) selon la revendication 9, au moins deux des ouvertures (3, 5, 7, 9) étant reliées à un système de refroidissement du véhicule.
